# FASCICULE DE BREVET EUROPEEN

(11) **EP 3 627 164 B1**
(45) Date de publication et mention de la délivrance du brevet: **09.08.2023**
(21) Numéro de dépôt: 19195694.5
(22) Date de dépôt: 05.09.2019
(51) Int. Cl.: G01R 31/327

(54) **SYSTEME COMPRENANT UN DISPOSITIF DE COMMANDE D'UN DISJONCTEUR ULTRA-RAPIDE D'UNE INSTALLATION ELECTRIQUE ET PROCEDE DE TEST D'UN TEL SYSTEME**
SYSTEM MIT EINER STEUERVORRICHTUNG EINES SCHNELLSCHALTERS EINER ELEKTRISCHEN ANLAGE, UND TESTVERFAHREN DIESES SYSTEMS
SYSTEM COMPRISING A DEVICE FOR CONTROLLING A HIGH-SPEED CIRCUIT BREAKER OF AN ELECTRICAL INSTALLATION AND METHOD FOR TESTING SUCH A SYSTEM

(30) Priorité: 18.09.2018 FR 1858440; 11.02.2019 FR 1901340
(43) Date de publication de la demande: 25.03.2020
(73) Titulaire: Soreel Societe de Realisation d'Equipements Electriques, 49304 Cholet Cedex (FR)
(72) Inventeur: DAMNEY, Pierre-Yves, 49300 CHOLET (FR); LE GUEN, Elisabeth, 85290 MORTAGNE SUR SEVRE (FR); BESSON, Maëlle, 49120 CHEMILLE EN ANJOU (FR)
(74) Mandataire: Vidon Brevets & Stratégie

(56) Documents cités:
- FR-A1- 2 489 038
- FR-A1- 2 500 927
- FR-A1- 2 556 904
- FR-A1- 2 651 915
- FR-A1- 2 843 676
- FR-A1- 3 028 894
- US-A- 5 629 610
- US-A1- 2008 007 883
- US-A1- 2017 110 870

## Description

### 1. Domaine de l'invention

Le domaine de l'invention est celui des installations électriques, et plus particulièrement du pilotage des organes de sécurité d'une installation électrique.

Plus particulièrement encore, l'invention concerne un dispositif de commande d'un disjoncteur ultra rapide.

L'invention trouve notamment son application dans le domaine de l'alimentation électrique des réseaux ferroviaires, en particulier pour les réseaux de tramway, RER ("réseau express régional") et de métro.

### 2. Art antérieur

Il est connu de sécuriser les installations électriques en plaçant des dispositifs de protection en court-circuit, tels que des disjoncteurs ou des fusibles, dont la fonction est d'interrompre le courant électrique en cas d'incident sur le circuit électrique.

L'avantage des disjoncteurs par rapport aux fusibles est qu'ils sont réarmables, c'est-à-dire qu'ils peuvent être réutilisés du fait qu'ils ne sont pas censés subir des avaries lors du fonctionnement.

Pour les réseaux électriques du domaine ferroviaire, qui fonctionnent en courant continu et à des tensions comprises entre 750 et 3000V, les éléments de sécurisation du réseau comprennent, de manière classique, des disjoncteurs ultra rapides (ou DUR), c'est-à-dire ayant une vitesse d'ouverture rapide.

Les normes NF EN 50126, NF EN 50 128, NF EN 50129 et IEC 61508 sont applicables à l'ensemble des acteurs du secteur ferroviaire et définissent des niveaux de sécurité permettant de réaliser des produits en adéquation avec les attentes sécuritaires.

Pour les disjoncteurs ultra rapides et leur circuit de commande, il est nécessaire s'assurer, qu'en cas d'incident électrique, ils puissent pleinement remplir leur rôle.

Classiquement, un disjoncteur ultra rapide est équipé d'une bobine de commande pour ouvrir ou fermer le disjoncteur, et est piloté par un relais de protection.

Pour tester le bon fonctionnement du relais de protection, il a été proposé de le faire commuter de manière régulière afin de vérifier qu'il passe bien d'un état ouvert à un état fermé.

Un impératif est qu'une telle commutation doit se faire rapidement de sorte à ne pas couper le circuit de commande du disjoncteur, et donc l'alimentation du réseau électrique. Or, une bobine de solénoïde d'un disjoncteur ultra rapide se démagnétise, de manière classique, en environ 6 millisecondes (ou ms). Or, il faut environ 5 millisecondes pour qu'un relais de protection commute, soit environ 10 millisecondes pour que le relais s'ouvre et se ferme. Ainsi, le temps que le relais soit ouvert puis fermé, la bobine de solénoïde du disjoncteur ultra rapide se décharge et le réseau électrique est coupé par le déclenchement du disjoncteur par la bobine.

Il a été proposé de mettre en oeuvre dans le circuit de commande d'un tel disjoncteur deux transistors en série et de vérifier la tension aux bornes de chaque transistor pour s'assurer du bon fonctionnement du circuit.

Toutefois, un inconvénient d'une telle solution est qu'elle met en oeuvre deux modes communs.

Ainsi, il est possible que, si l'un des deux transistors est inutilisable (par exemple à cause d'un court-circuit ou d'une surtension), l'autre soit également inutilisable car ce qui provoque une avarie de l'un a de fortes chances de provoquer une avarie de l'autre transistor.

Ainsi, les circuits de commande actuels des disjoncteurs ne peuvent pas être testés en continu sans provoquer une interruption du fonctionnement de l'installation électrique.

Il est aussi connu de la demande FR2843676 un dispositif de commande d'une lampe, le dispositif comprenant un relais de pilotage dont la borne d'entrée est reliée à des moyens d'alimentation électrique et la borne de sortie est reliée à un transistor de puissance, la borne de sortie du transistor de puissance étant reliée à ladite lampe, et aussi des moyens de contrôle en continu de l'état de fonctionnement dudit transistor de puissance de ladite lampe, lesdits moyens de contrôle continu comprenant un circuit de commande du transistor de puissance apte à générer une impulsion électrique prédéterminée destinée à faire commuter ledit transistor de puissance.

### 3. Objectifs de l'invention

L'invention a notamment pour objectif de pallier ces inconvénients de l'art antérieur.

Plus précisément, un objectif de l'invention est de fournir un circuit de commande d'un disjoncteur qui soit fiable.

Un autre objectif de l'invention est de fournir une technique permettant de s'assurer du bon fonctionnement d'un tel circuit de commande sans affecter ou interrompre le fonctionnement de l'installation électrique.

L'invention a également pour objectif de fournir une telle technique qui soit relativement peu coûteuse à mettre en oeuvre et qui réponde aux exigences du ferroviaire et des normes en vigueur.

### 4. Exposé de l'invention

Ces objectifs, ainsi que d'autres qui apparaitront par la suite sont atteints selon l'invention à l'aide d'un système conforme à la revendication 1.

L'invention propose donc un système pour l'essai du circuit de commande d'un disjoncteur d'une installation électrique, sans interruption du fonctionnement de celle-ci. Cette fonction surveille en permanence le circuit de commande afin de s'assurer qu'il est apte à déclencher le disjoncteur ultra rapide sans interrompre le fonctionnement de l'installation dans laquelle sont mis en oeuvre le disjoncteur et son circuit de commande. Le relais de protection est associé du côté de sa sortie à un transistor que l'on commande en commutation. S'il est détecté que le transistor ne commute, une anomalie est identifiée et le disjoncteur n'est plus alimenté jusqu'à ce que l'anomalie soit résolue.

Avantageusement, lesdits moyens de contrôle continu comprennent en outre un circuit de mesure de la tension aux bornes dudit transistor de puissance, ledit circuit de mesure de la tension aux bornes dudit transistor de puissance comprenant une première portion de circuit située en amont dudit transistor de puissance et une deuxième portion de circuit située en aval dudit transistor de puissance.

De façon préférentielle, ladite impulsion électrique prédéterminée est une microcoupure de tension de durée comprise entre 0,1 ms et 1 ms.

Selon une mise en oeuvre particulière, ladite impulsion électrique est appliquée périodiquement, la période étant sensiblement égale à un dixième de milliseconde.

De façon préférentielle, ledit transistor de puissance (2) présente un temps de commutation de 100 ns.

Selon une mise en oeuvre particulière, le dispositif comprend en outre un circuit de commande dudit relais de pilotage.

De façon préférentielle, ladite borne de sortie dudit transistor de puissance est une sortie « tout ou rien ».

De façon avantageuse, ledit transistor de puissance et ledit relais de pilotage sont binairement commandés en opposé.

Selon une mise en oeuvre particulière, les moyens d'alimentation électrique alimentent l'installation électrique par un courant continu.

L'invention concerne également un procédé de test d'un système tel que décrit précédemment, et tel que définit dans la revendication 10, le procédé comprenant les étapes suivantes :
- une étape de génération d'une impulsion électrique prédéterminée destinée à faire commuter ledit transistor de puissance en réponse à ladite impulsion électrique prédéterminée ;
- une étape de mesure de la tension en amont et en aval dudit transistor de puissance;
- une étape de comparaison entre la tension mesurée en amont et en aval dudit transistor de puissance en fonction de l'état dudit transistor de puissance, de sorte à contrôler le bon fonctionnement dudit transistor de puissance.

Préférentiellement, ladite étape de génération d'une impulsion électrique prédéterminée étant de durée comprise entre 0,1 ms et 1 ms.

De façon avantageuse, le procédé de test est répété périodiquement, la période étant sensiblement égale à un dixième de milliseconde.

Selon une mise en oeuvre particulière, le procédé de test comprend en outre une étape de contrôle de l'état de fonctionnement dudit relais de pilotage.

Préférentiellement, si une anomalie est détectée à l'étape de comparaison entre la tension mesurée en amont et en aval dudit transistor de puissance en fonction de l'état dudit transistor de puissance, le procédé comprend une étape de coupure de la tension au niveau de ladite borne de sortie dudit transistor de puissance.

### 5. Liste des figures

D'autres caractéristiques avantageuses de l'invention apparaîtront plus clairement à la lecture de la description suivante d'un mode de réalisation préférentiel de l'invention, donné à titre de simple exemple illustratif et non limitatif et des dessins annexés parmi lesquels :
**[****Fig. 1****]** présente un schéma fonctionnel simplifié d'un dispositif de commande d'un disjoncteur ultra rapide selon un mode de réalisation de l'invention ;
**[****Fig. 2****]** représente une table de vérité des circuits de mesure de tension mis en oeuvre dans le dispositif de commande selon le mode de réalisation de la **[****Fig. 1****];**
**[****Fig. 3****]** illustre le schéma électrique du dispositif de commande selon le mode de réalisation de la **[****Fig. 1****],** le disjoncteur ultra rapide n'étant pas représenté, et
**[****Fig. 4****]** est une représentation d'un signal de test du transistor du dispositif de commande, selon le mode de réalisation des figures précédentes.

### 6. Description d'un mode de réalisation

Les disjoncteurs ultra rapides, lorsqu'ils sont mis en oeuvre dans le domaine ferroviaire, permettent de protéger et d'isoler la section, ou sous station, de la ligne aérienne de contact (ligne d'alimentation au-dessus du matériel roulant, par exemple pour un tramway), ou de la ligne au sol de contact (ligne d'alimentation sous le matériel roulant, par exemple pour un métro) contre les défauts et les éventuelles surcharges. Ils peuvent, par exemple, être sécurisés par un verrouillage mécanique, afin de permettre une éventuelle action de maintenance sur la section électrique en toute sécurité. Enfin, ils sont aptes à communiquer avec les disjoncteurs des sous-stations adjacentes.

De sorte à remplir sa fonction, le disjoncteur ultra rapide comporte un circuit interne de coupure comprenant une bobine électromagnétique de commande. Cette bobine présente un temps de démagnétisation de plusieurs millisecondes, généralement de l'ordre de 5 à 10 millisecondes. De cette manière, le disjoncteur ultra rapide est protégé contre les microcoupures qui pourraient avoir lieu au sein du circuit électrique dans lequel il est placé, et ne disjonctera pas à chaque microcoupure inférieure au temps de démagnétisation de la bobine.

Afin de commander un tel disjoncteur ultra rapide, et notamment de le faire commuter lorsqu'une défaillance est détectée dans le circuit électrique dans lequel il est situé, l'invention propose un dispositif de commande de structure nouvelle.

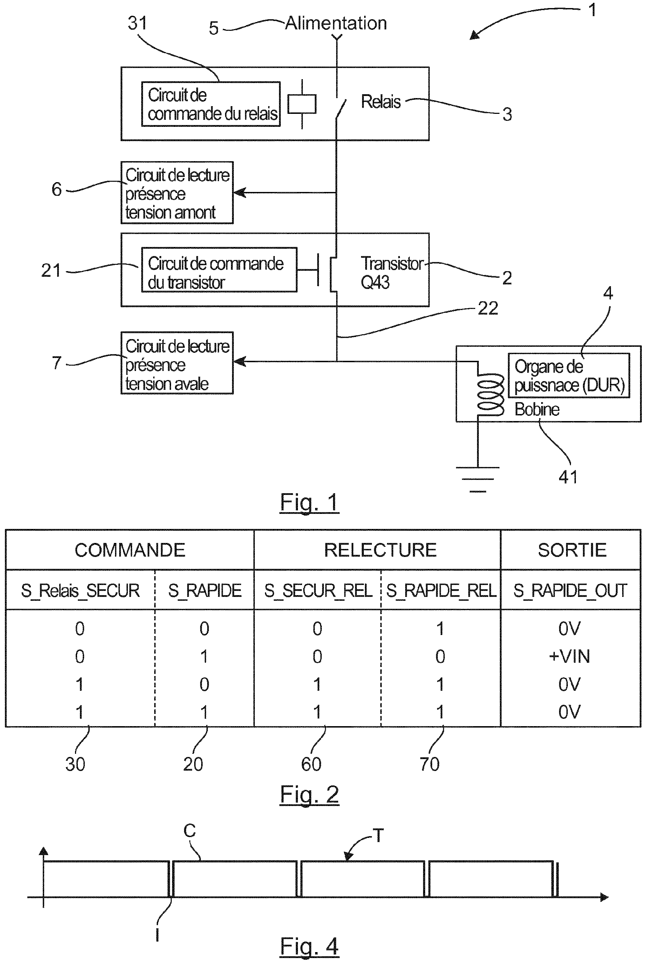

On présente maintenant, en relation avec les figures 1 à 4, un système comprenant un dispositif de commande d'un disjoncteur ultra rapide selon un mode de réalisation de l'invention.

Comme illustré en figure 1, le dispositif de commande ou de pilotage 1 d'un organe de coupure d'une installation électrique, qui est selon l'invention un disjoncteur ultra-rapide 4, comprend un relais de puissance, dit de pilotage, 3 constituant un interrupteur et comprenant une bobine commandant un contact. La borne d'entrée du relais de pilotage 3 est reliée à des moyens d'alimentation électrique 5 et sa borne de sortie est reliée à un transistor de puissance 2 formant un interrupteur, la borne de sortie du transistor de puissance 2, dite sortie rapide, étant reliée au disjoncteur ultra-rapide 4.

Ainsi, le relais de pilotage 3 et le transistor de puissance 2 sont montés en série dans le circuit d'alimentation de la bobine de commande du disjoncteur ultra rapide 4, la bobine de commande étant destinée à fermer ou ouvrir le disjoncteur lorsqu'elle est alimentée ou non, respectivement.

Selon un aspect d'un mode de réalisation, cette borne d'entrée du relais de pilotage peut par exemple comprendre un condensateur coudé

Dans ce mode de réalisation, les moyens d'alimentation électrique fournissent un courant continu.

Le courant transitant dans le disjoncteur ultra-rapide peut varier de 0 A à 8 kA en nominal et peut tolérer des défauts jusqu'à 100 kA.

Selon un mode de réalisation, de sorte à protéger l'installation en cas, notamment, d'erreur de branchement (inversion des pôles par exemple), le dispositif de commande peut en outre comprendre au moins une diode de protection, par exemple une première diode 8 en série avec une diode Zener 9.

La mise en oeuvre du relais de pilotage 3 et du transistor de puissance 2 permet d'obtenir un double niveau de sûreté de fonctionnement, sans mode commun, de sorte à pouvoir, par exemple en cas de détection d'une anomalie sur le circuit électrique, permettre le déclenchement du disjoncteur ultra rapide 4.

Le transistor de puissance 2 est, dans ce mode de réalisation, un transistor MOSFET de type n (présentant une grille, un drain et une source). On rappelle que lorsque la tension grille-source V_{GS} est inférieure à la tension de seuil, on dit que le transistor est bloqué, il ne conduit pas. Dans le cas contraire, on dit qu'il est passant, et dans ce cas, il conduit le courant entre le drain et la source. Ainsi le transistor de puissance 2 peut commuter selon la tension appliquée entre la grille et la source.

Pour répondre aux modes de défaillance (bloqué ouvert ou bloqué fermé) du transistor de puissance 2, le relais de pilotage 3 est disposé en série (pour le mode bloqué fermé) et dans le mode bloqué ouvert, le danger pour les personnes est nul car le disjoncteur ultra rapide 4 est bloqué ouvert.

L'invention propose de vérifier en cours de fonctionnement que le transistor de puissance 2 et le relais de pilotage 3 ont les capacités de commuter.

Pour ce faire, le dispositif de commande ou de pilotage 1 comprend des moyens de contrôle en continu de l'état de fonctionnement du transistor de puissance 2, lesdits moyens de contrôle en continu comprenant un circuit de commande 21 apte à générer une impulsion électrique prédéterminée destinée à faire commuter ledit transistor de puissance 2.

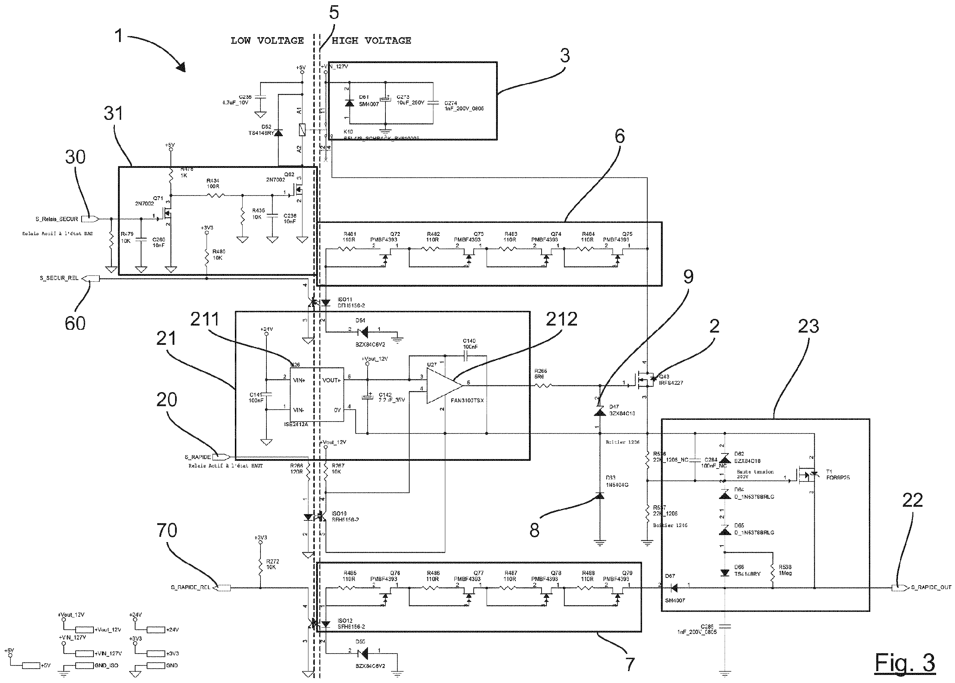

Comme illustré en figure 3, dans ce mode de réalisation, le circuit de commande 21 du transistor de puissance 2 comprend un convertisseur de tension, 211 et un amplificateur opérationnel 212 qui est monté selon un montage suiveur.

Le circuit de commande 21 est configuré pour injecter un signal de test sur la grille du transistor de puissance 2.

Le convertisseur de tension 211 est plus particulièrement programmé pour établir une séquence d'essais prédéterminée de sorte à déterminer le fonctionnement ou le non fonctionnement du transistor de puissance 2 en continu. Ceci permet de tester à tout moment l'état de fonctionnement du circuit de commande du disjoncteur.

Le test est effectué par l'intermédiaire d'un programme exécuté par le convertisseur de tension 211. Ce test peut être déclenché périodiquement.

De cette manière, un dysfonctionnement du transistor de puissance 2 (qui correspond au blocage du transistor en positon ouverte ou fermée) peut être détecté lorsque ce dernier ne commute pas en réponse à une impulsion électrique prédéterminée envoyée par le circuit de commande 2. Cette impulsion électrique correspond à une microcoupure de tension de durée comprise entre 0,1ms et 1ms.

Il est à noter que, dans ce mode de réalisation, le transistor de puissance 2 a un temps de commutation de 100 ns.

Dans le présent mode de réalisation, le signal de test illustré en figure 4 comprend une impulsion électrique périodique, la période étant comprise entre X et Y secondes.

Dans le mode de réalisation décrit, cette période est de l'ordre du dixième de milliseconde.

Pour vérifier si la commutation du transistor de puissance 2 est effective en réponse à une impulsion électrique prédéterminée, les moyens de contrôle en continu comprennent en outre un circuit de mesure de la tension aux bornes du transistor de puissance 2.

Le convertisseur de tension 211 détecte ainsi la tension aux bornes du transistor de puissance 2 par le biais d'un circuit de mesure de tension qui est monté en dérivation aux bornes du transistor de puissance 2 pour détecter un état de conduction ou de non conduction de celui-ci aux fins de réaliser un test de son bon fonctionnement.

Ce circuit de mesure de la tension aux bornes du transistor de puissance 2 comprend une première portion 6 de circuit placée en amont du transistor de puissance 4 et une deuxième portion 7 de circuit placée en aval du transistor de puissance 4.

Comme illustré en figure 3, dans ce mode de réalisation, chacune de ces deux portions 6, 7 du circuit de mesure de la tension aux bornes du transistor de puissance est muni d'une pluralité de modules, chacun de ces modules comprenant un transistor relié à une résistance.

En effet, en générant des impulsions électriques, on incite le transistor de puissance 2 à commuter. Si la valeur de tension aux bornes du transistor de puissance 2 ne change pas alors il est déterminé que ce dernier est bloqué en position ouverte ou fermée. Dans le cas contraire, si la valeur de tension aux bornes du transistor de puissance 2 change, il est déterminé que ce dernier est en bon état de fonctionnement, et est apte à remplir son rôle de coupure de l'installation en cas de besoin.

De sorte à effectuer cette vérification, ce dispositif de commande 1 met en oeuvre un procédé de test, également objet de l'invention.

Ce procédé de test comprend les étapes suivantes :
- une étape de génération d'une impulsion électrique prédéterminée destinée à faire commuter le transistor de puissance 2 en réponse à l'impulsion électrique prédéterminée ;
- une étape de mesure de la tension en amont et en aval du transistor de puissance 2 ;
- une étape de comparaison entre la tension mesurée en amont et en aval du transistor de puissance 2 en fonction de l'état dudit transistor de puissance 2, de sorte à contrôler le bon fonctionnement du transistor de puissance 2.

Comme décrit précédemment, l'étape de génération d'une impulsion électrique prédéterminée est mise en oeuvre, selon les modes de réalisation, pendant une durée comprise entre 0,1 ms et 1 ms.

En outre, de sorte à ce que le contrôle soit continu, et selon le mode de réalisation présenté, le procédé de test est répété périodiquement, la période étant de l'ordre du dixième de milliseconde

De cette manière, la commutation du transistor de puissance 2 est testée à chaque période.

A chaque période, correspondant à chaque itération du procédé, la tension en amont et en aval du transistor de puissance 2 est mesurée puis est comparée en fonction de l'état dudit transistor de puissance 2, de sorte à contrôler le bon fonctionnement du transistor de puissance 2.

On présente en figure 2 une table de vérité représentant l'état de la tension sur la borne de sortie (aval) 22 du transistor.

Il est à noter que cette borne de sortie 22 du transistor de puissance 2 est une sortie « tout ou rien », qui laisse donc passer, soit l'intégralité du courant, soit aucun courant, selon l'état de commutation du transistor.

En outre, afin de protéger cette sortie 22 de pics de courant et de tension, notamment rencontrés lors d'ouvertures du disjoncteur ultra-rapide, un circuit de protection 23 est mis en oeuvre à proximité de cette borne de sotie 22.

Un tel circuit de protection comprend, dans ce mode de réalisation, une pluralité de diodes « de roue libre » et d'un transistor MOSFET de type n.

Par ailleurs, le transistor de puissance 2 et le relais de pilotage 3 sont binairement commandés en opposé. En d'autres termes, le relais de pilotage 3 est actif (fermé) avec une commande à 0 et inactif (ouvert) avec une commande à 1 tandis que le transistor de puissance est actif (fermé) avec une commande à 1 et inactif (ouvert) avec une commande à 0.

Ceci permet de s'assurer que le disjoncteur ultra rapide puisse être ouvert lorsque le transistor de puissance 2 est défaillant (bloqué ouvert ou bloqué fermé).

Comme illustré en figure 2, dans une première situation (correspondant à la première ligne de la table de vérité), lorsque le relais de pilotage est actif et que le transistor de puissance est inactif, la première portion 6 de circuit de mesure détecte une tension en amont du transistor de puissance 2 tandis qu'aucune tension n'est détectée en aval du transistor de puissance 2 par la deuxième portion 7 de circuit de mesure. La borne de sortie 22 du transistor de puissance 2 présente un courant nul.

Dans une deuxième situation, lorsque le relais de pilotage 3 est actif et que le transistor de puissance 2 est actif, les première 6 et deuxième 7 portions de circuit détectent une tension. La borne de sortie 22 du transistor de puissance 2 présente un courant positif.

Dans une troisième situation, lorsque le relais de pilotage 3 est inactif et que le transistor de puissance 2 est inactif, les première 6 et deuxième 7 portions de circuit ne détectent aucune tension. La borne de sortie 22 présente un courant nul.

Enfin, dans une quatrième situation, lorsque le relais de pilotage 3 est inactif et que le transistor de puissance est actif, la première portion 6 de circuit de mesure ne détecte aucune tension en amont du transistor de puissance 2 tandis qu'aucune tension n'est détectée en aval du transistor de puissance 2 par la deuxième portion 7 de circuit de mesure. La borne de sortie 22 du transistor de puissance 2 présente un courant nul.

Ainsi, lorsqu'une anomalie est détectée à l'étape de comparaison entre la tension mesurée en amont et en aval du transistor de puissance 2 (typiquement les première et quatrième situations), en fonction de l'état du transistor de puissance 2, cette anomalie est remontée par logiciel pour déclencher le « watchdog ». Cette information force l'ouverture du disjoncteur ultra rapide.

Il est à noter que, selon un mode de réalisation, ce « watchdog » peut également se déclencher si aucune tension n'est détectée en amont et en aval.

Cette étape de coupure peut, selon le mode de réalisation présenté, apparaître au bout d'un nombre prédéterminé d'itérations.

En d'autres termes, avant d'ouvrir le disjoncteur ultra-rapide, le procédé de test peut être itéré une ou plusieurs fois, de sorte à s'assurer que l'anomalie est bien réelle, ceci afin d'éviter que l'ouverture du disjoncteur ultra-rapide ne soit faite par la transmission d'une anomalie inexistante. Cette pluralité d'itérations permet ainsi de s'assurer de la véracité de cette anomalie avec une fiabilité renforcée.

Par exemple, on peut prévoir qu'au bout d'une dizaine d'itérations présentant une anomalie, le procédé comprend une étape de coupure de la tension sortant de la borne de sortie 22 du transistor de puissance 2.

On peut également prévoir qu'au bout de cinq itérations, par exemple, présentant une anomalie, le procédé comprend l'étape de coupure de la tension sortant de la borne de sortie 22 du transistor de puissance 2.

Une telle temporisation permet notamment d'écarter un risque de mauvaise décision d'ouverture du disjoncteur ultra rapide.

Selon un mode de réalisation particulier, le procédé peut comprendre en outre une étape de contrôle de l'état de fonctionnement du relais de pilotage 3.

Une telle étape de contrôle de l'état de fonctionnement du relais de pilotage 3 peut par exemple être mise en oeuvre avant chaque redémarrage du réseau électrique, ou lors de phases de maintenance périodiques (mensuelle, annuelle).

Cette étape de contrôle peut permettre également de déterminer s'il faut activer ou non le relais de pilotage, par le biais du circuit de commande du relais.

La condition de fermeture du relais de pilotage peut comprendre une pluralité de conditions préalables tel que l'état « prêt » du relais de pilotage, l'absence de défaut détecté dans le réseau électrique et notamment au niveau du transistor.

Il est à noter qu'en cas d'absence d'alimentation du relais de pilotage, le relais n'étant pas alimenté, le circuit est ouvert et le disjoncteur ultra rapide également.

Les phases de maintenance périodique peuvent également comprendre des étapes de contrôle de commutations (ouverture et fermeture) du relais de pilotage 3 et du transistor de puissance 2.

Une telle phase de maintenance peut consister en un test comprenant les étapes suivantes :
- manoeuvre d'ouverture (ou désactivation) et fermeture (ou activation) du relais de pilotage et/ou du transistor de puissance ;
- mesure du temps de réponse du relais de pilotage et/ou du transistor de puissance ;
- mesure du temps de réponse du réseau électrique en globalité.

Il est à noter que le procédé de test de dispositif peut être adapté pour tout type de disjoncteur ultra-rapide.

Par exemple, on pourrait prévoir que le disjoncteur ultra-rapide soit un disjoncteur 24 V, 48 V voire 127 V.

## Revendications

1. Système comprenant un dispositif de commande (1) et un disjoncteur ultra rapide (4), ledit dispositif de commande (1) comprenant un relais de pilotage (3) dont la borne d'entrée est reliée à des moyens d'alimentation électrique (5) et la borne de sortie est reliée à un transistor de puissance (2), la borne de sortie (22) du transistor de puissance (2) étant reliée audit disjoncteur ultra rapide (4), le dispositif comprenant en outre des moyens de contrôle en continu de l'état de fonctionnement dudit transistor de puissance (2), lesdits moyens de contrôle continu comprenant un circuit de commande (21) du transistor de puissance (2) apte à générer une impulsion électrique prédéterminée destinée à faire commuter ledit transistor de puissance (2), un dysfonctionnement dudit transistor de puissance (2) étant détecté lorsque ce dernier ne commute pas en réponse à ladite impulsion électrique prédéterminée.

2. Système selon la revendication 1, **caractérisé en ce que** lesdits moyens de contrôle continu comprennent en outre un circuit de mesure de la tension aux bornes dudit transistor de puissance (2), ledit circuit de mesure de la tension aux bornes dudit transistor de puissance (2) comprenant une première portion (6) de circuit située en amont dudit transistor de puissance (2) et une deuxième portion (7) de circuit située en aval dudit transistor de puissance (2).

3. Système selon l'une des revendications 1 ou 2, **caractérisé en ce que** ladite impulsion électrique prédéterminée est une microcoupure de tension de durée comprise entre 0,1 ms et 1 ms.

4. Système selon la revendication 3, **caractérisé en ce que** ladite impulsion électrique est appliquée périodiquement, la période étant sensiblement égale à un dixième de milliseconde.

5. Système selon l'une des revendications 1 à 4, ledit transistor de puissance (2) présente un temps de commutation de 100 ns.

6. Système selon l'une des revendications 1 à 5, **caractérisé en ce que** le dispositif comprend en outre un circuit de commande (31) dudit relais de pilotage (3).

7. Système selon l'une des revendications 1 à 6, **caractérisé en ce que** ladite borne de sortie (22) dudit transistor de puissance (2) est une sortie « tout ou rien ».

8. Système selon l'une des revendications 1 à 7, **caractérisé en ce que** ledit transistor de puissance (2) et ledit relais de pilotage (3) sont binairement commandés en opposé.

9. Système selon l'une des revendications 1 à 8, **caractérisé en ce que** les moyens d'alimentation électrique (5) alimentent l'installation électrique par un courant continu.

10. Procédé de test d'un système selon l'une des revendications 1 à 9, le procédé comprenant les étapes suivantes :
- une étape de génération d'une impulsion électrique prédéterminée destinée à faire commuter ledit transistor de puissance (2) en réponse à ladite impulsion électrique prédéterminée ;
- une étape de mesure de la tension en amont et en aval dudit transistor de puissance (2) ;
- une étape de comparaison entre la tension mesurée en amont et en aval dudit transistor de puissance (2) en fonction de l'état dudit transistor de puissance (2), de sorte à contrôler le bon fonctionnement dudit transistor de puissance (2).

11. Procédé de test selon la revendication 10, ladite étape de génération d'une impulsion électrique prédéterminée étant de durée comprise entre 0,1 ms et 1 ms.

12. Procédé de test selon l'une des revendications 10 ou 11, **caractérisé en ce qu'**il est répété périodiquement, la période étant sensiblement égale à un dixième de milliseconde.

13. Procédé de test selon l'une des revendications 10 à 12, **caractérisé en ce qu'**il comprend en outre une étape de contrôle de l'état de fonctionnement dudit relais de pilotage (3).

14. Procédé de test selon l'une des revendications 10 à 13, **caractérisé en ce que**, si une anomalie est détectée à l'étape de comparaison entre la tension mesurée en amont et en aval dudit transistor de puissance (2) en fonction de l'état dudit transistor de puissance (2), le procédé comprend une étape de coupure de la tension au niveau de ladite borne de sortie (22) dudit transistor de puissance (2).

## Patentansprüche

1. System, das eine Steuervorrichtung (1) und einen Schnellschalter (4) umfasst,
wobei die Steuervorrichtung (1) ein Steuerrelais (3) umfasst, dessen Eingangsklemme mit Stromversorgungsmitteln (5) verbunden ist, und die Ausgangsklemme mit einem Leistungstransistor (2) verbunden ist, wobei die Ausgangsklemme (22) des Leistungstransistors (2) mit dem Schnellschalter (4) verbunden ist, und die Vorrichtung außerdem Mittel zur kontinuierlichen Kontrolle des Betriebszustands des Leistungstransistors (2) umfasst, wobei die Mittel zur kontinuierlichen Kontrolle eine Steuerschaltung (21) des Leistungstransistors (2) umfassen, die dazu geeignet ist, einen vorbestimmten elektrischen Impuls zu erzeugen, der den Leistungstransistor (2) umschalten lassen soll, wobei eine Funktionsstörung des Leistungstransistors (2) erfasst wird, wenn dieser Letztere als Reaktion auf den vorbestimmten elektrischen Impuls nicht umschaltet.

2. System nach Anspruch 1, **dadurch gekennzeichnet, dass** die Mittel zum kontinuierlichen Kontrollieren außerdem eine Messschaltung der Spannung an den Klemmen des Leistungstransistors (2) umfassen, wobei die Messschaltung der Spannung an den Klemmen des Leistungstransistors (2) einen ersten Schaltungsabschnitt (6) umfasst, der stromaufwärts des Leistungstransistors (2) liegt, und einen zweiten Schaltungsabschnitt (7), der stromabwärts des Leistungstransistors (2) liegt.

3. System nach einem der Ansprüche 1 oder 2, **dadurch gekennzeichnet, dass** der vorbestimmte elektrische Impuls eine Mikrospannungsunterbrechung mit einer Dauer von zwischen 0,1 ms und 1 ms ist.

4. System nach Anspruch 3, **dadurch gekennzeichnet, dass** der elektrische Impuls periodisch angelegt wird, wobei die Periode im Wesentlichen gleich einem Zehntel von 30 Millisekunde ist.

5. System nach einem der Ansprüche 1 bis 4, wobei der Leistungstransistor (2) eine Schaltzeit von 100 ns aufweist.

6. System nach einem der Ansprüche 1 bis 5, **dadurch gekennzeichnet, dass** die Vorrichtung außerdem eine Steuerschaltung (31) des Steuerrelais (3) umfasst.

7. System nach einem der Ansprüche 1 bis 6, **dadurch gekennzeichnet, dass** die Ausgangsklemme (22) des Leistungstransistors (2) ein "binärer" Ausgang ist.

8. System nach einem der Ansprüche 1 bis 7, **dadurch gekennzeichnet, dass** der Leistungstransistor (2) und das Steuerrelais (3) binär gegenläufig gesteuert sind.

9. System nach einem der Ansprüche 1 bis 8, **dadurch gekennzeichnet, dass** die Stromversorgungsmittel (5) die elektrische Anlage mit einem Gleichstrom versorgen.

10. Testverfahren eines Systems nach einem der Ansprüche 1 bis 9, wobei das Verfahren die folgenden Schritte umfasst:
- einen Erzeugungsschritt eines vorbestimmten elektrischen Impulses, der dazu bestimmt ist, den Leistungstransistor (2) als Reaktion auf den vorbestimmten elektrischen Impuls umschalten zu lassen;
- einen Messschritt der Spannung stromaufwärts und stromabwärts des Leistungstransistors (2);
- einen Vergleichsschritt zwischen der stromaufwärts und stromabwärts gemessenen Spannung des Leistungstransistors (2) in Abhängigkeit von dem Zustand des Leistungstransistors (2), um das gute Funktionieren des Leistungstransistors (2) zu kontrollieren.

11. Testverfahren nach Anspruch 10, wobei der Erzeugungsschritt eines vorbestimmten elektrischen Impulses eine Dauer von zwischen 0,1 ms und 1 ms aufweist.

12. Testverfahren nach einem der Ansprüche 10 oder 11, **dadurch gekennzeichnet, dass** es periodisch wiederholt wird, wobei die Periode im Wesentlichen gleich einem Zehntel Millisekunde ist.

13. Testverfahren nach einem der Ansprüche 10 bis 12, **dadurch gekennzeichnet, dass** es außerdem einen Steuerschritt des Betriebszustands des Steuerrelais (3) umfasst.

14. Verfahren nach einem der Ansprüche 10 bis 13, **dadurch gekennzeichnet, dass**, falls eine Anomalie bei dem Vergleichsschritt zwischen der stromaufwärts und der stromabwärts von dem Leistungstransistor (2) gemessenen Spannung in Abhängigkeit von dem Zustand des Leistungstransistors (2) erfasst wird, das Verfahren einen Schritt des Unterbrechens der Spannung an der Ausgangsklemme (22) des Leistungstransistors (2) umfasst.

## Claims

1. System comprising a control device (1) and a high-speed circuit-breaker (4), said control device (1) comprising a drive relay (3) the input terminal of which is connected to electric supply means (5) and the output terminal is connected to a power transistor (2), the output terminal (22) of the power transistor (2) being connected to said high-speed circuit-breaker (4),
the device further comprising means for continuously checking the operation state of said power transistor (2), said continuous check means comprising a circuit (21) for controlling the power transistor (2) capable of generating a predetermined electric pulse for switching said power transistor (2), a malfunction of said power transistor (2) being detected when the latter does not switch in response to said predetermined electric pulse.

2. System according to claim 1, **characterized in that** said continuous check means further comprise a circuit for measuring voltage across said power transistor (2), said circuit for measuring voltage across said power transistor (2) comprising a first circuit portion (6) located upstream of said power transistor (2) and a second circuit portion (7) located downstream of said power transistor (2).

3. System according to one of claims 1 or 2, **characterized in that** said predetermined electric pulse is a brown-out having a duration of between 0.1 ms and 1 ms.

4. System according to claim 3, **characterized in that** said electric pulse is periodically applied, the period being substantially equal to one tenth of a millisecond.

5. System according to one of claims 1 to 4, said power transistor (2) has a switching time of 100 ns.

6. System according to one of claims 1 to 5, **characterized in that** the device further comprises a circuit (31) for controlling said drive relay (3).

7. System according to one of claims 1 to 6, **characterized in that** said output terminal (22) of said power transistor (2) is an "on-off" output.

8. System according to one of claims 1 to 7, **characterized in that** said power transistor (2) and said drive relay (3) are oppositely controlled in a binary manner.

9. System according to one of claims 1 to 8, **characterized in that** the electric supply means (5) supply the electrical facility with a direct current.

10. Method for testing a system according to one of claims 1 to 9, the method comprising the following steps:
- a step of generating a predetermined electric pulse for switching said power transistor (2) in response to said predetermined electric pulse;
- a step of measuring the voltage upstream and downstream of said power transistor (2);
- a step of comparing the voltage measured upstream and downstream of said power transistor (2) as a function of the state of said power transistor (2), so as to check proper operation of said power transistor (2).

11. Method for testing according to claim 10, said step of generating a predetermined electric pulse being of a duration of between 0.1 ms and 1 ms.

12. Method for testing according to one of claims 10 or 11, **characterized in that** it is periodically repeated, the period being substantially equal to one tenth of a millisecond.

13. Method for testing according to one of claims 10 to 12, **characterized in that** it further comprises a step of checking the operation state of said drive relay (3).

14. Method for testing according to one of claims 10 to 13, **characterized in that**, if an anomaly is detected in the step of comparing the voltage measured upstream and downstream of said power transistor (2) as a function of the state of said power transistor (2), the method comprises a step of cutting off voltage at said output terminal (22) of said power transistor (2).
